# EUROPEAN PATENT APPLICATION

(11) **EP 0 807 969 A1**
(43) Date of publication of application: **19.11.1997**
(21) Application number: 97302567.9
(22) Date of filing: 15.04.1997
(51) Int. Cl.: H01L 21/761, H01L 27/06

(54) **Semiconductor integrated circuit**

(30) Priority: 07.05.1996 GB 9609276
(71) Applicant: PLESSEY SEMICONDUCTORS LIMITED, Swindon, Wiltshire SN2 2QW (GB)
(72) Inventor: Klar, Adrian, 82008, Unterhaching (DE)
(74) Representative: Hoste, Colin Francis

(57) **Abstract**

A PNP transistor 18, 26, 27 formed on a P-type substrate 14 is isolated from the substrate 14 by an N-type isolation well 22, 15, 23. The potential of the isolation well 22, 15, 23 is controlled by connecting a resistor between the base 26 of the transistor and the well 22, 15, 23. The resistor is formed by a P-type layer 20 in an N-type isolation well 24, 16, 25 and is connected between the transistor isolation 23 and the base 26 by surface metallisation layers 28, 30. Preferably, the N-type isolation well 24, 25, 16 of the resistor is connected to the emitter of the transistor by a further metallisation layer 29.

## Description

The present invention relates to a semiconductor integrated circuit and more particularly, though not exclusively, to a semiconductor integrated circuit formed in or on a P-type substrate.

Where a PNP transistor is to be provided in an integrated circuit utilising mainly NPN transistors formed in or on a P-type substrate, it is necessary to provide isolation means around the PNP transistor, and the potential of the isolation means must be controlled so as to avoid turning on any inherent parasitic junctions or devices. Thus, where the isolation means is an N-type well in the P-type substrate, the material of the well must be connected to a potential which is equal to or more positive than the base electrode of the PNP device.

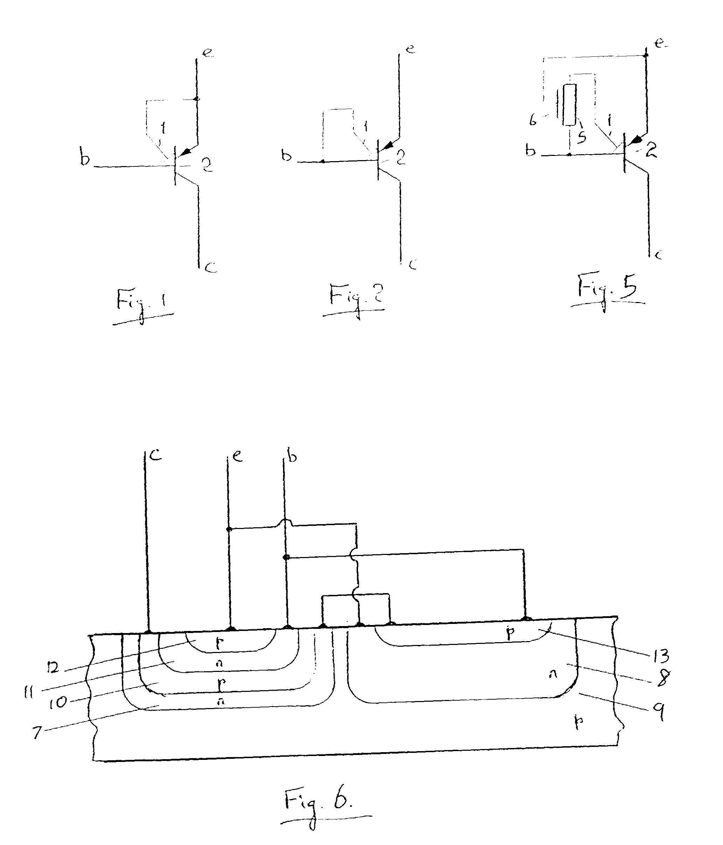

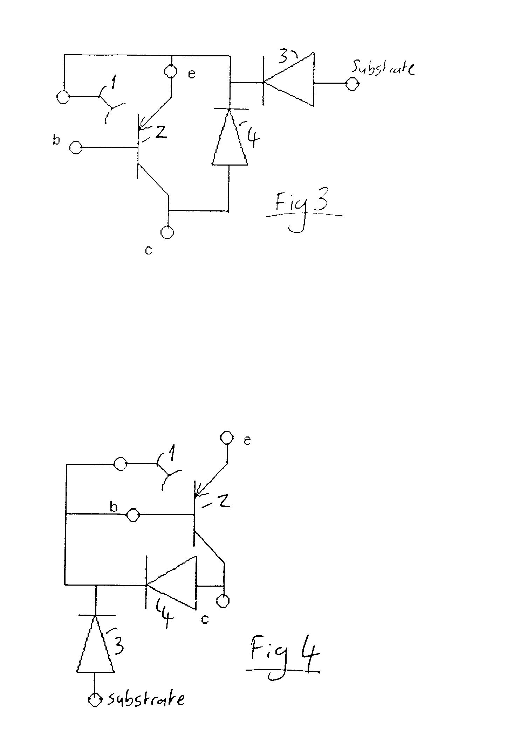

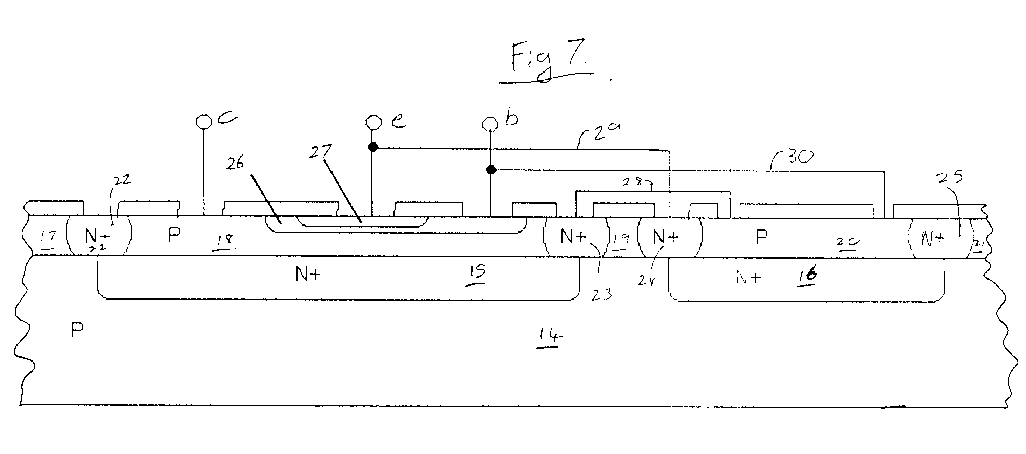

The choice of connection hitherto has at least to some extent been dependent on the nature of the signals to be handled. For linear applications, the isolation means may be connected to the emitter of the PNP transistor, as shown in Figure 1 and, as an equivalent circuit, in Figure 3. Two diodes 3, 4 are shown which represent the P-N junctions formed between the substrate and the N-type well and the collector and the N-type well respectively. The presence of these junctions gives transistor 2 a relatively low input capacitance at its base electrode but has the disadvantage of a high saturation voltage.

For switching applications, the isolation means may be connected to the base of the PNP transistor, as shown in Figure 2 and, as an equivalent circuit, in Figure 4. Here, the two P-N junctions 3, 4 give the transistor 2 a saturation voltage of about half that of the Figure 1 device, which is useful in switching applications, but with the disadvantage of an increased input capacitance. This capacitance can be seven times that of the base input capacitance of the Figure 1 device and can be problematic where circuit stability is concerned.

According to one aspect of the present invention in a semiconductor integrated circuit in which isolation means of a first conductivity type is provided around a bipolar transistor formed in a semiconductor substrate of conductivity type opposite to said first type, there are provided resistor means formed in said substrate for connecting the isolation means to the base electrode of the bipolar transistor.

According to another aspect of the present invention in a semiconductor integrated circuit in which a plurality of NPN bipolar transistors are formed in a P-type substrate, a PNP bipolar transistor is formed in an N-type well formed in said substrate, and there are provided resistor means formed in or on said substrate for connecting the N-type well to the base electrode of said PNP transistor.

Preferably said resistor means is formed in a separate N-type well.

A semiconductor integrated circuit in accordance with the present invention will now be described by way of example with reference to the accompanying drawings, of which: -
Figures 1 and 2 show symbolically respective known forms of integrated circuit,
Figures 3 and 4 show equivalent circuits of respective ones of the integrated circuits of Figures 1 and 2;
Figures 5 and 6 show respectively symbolically and diagrammatically an integrated circuit in accordance with the invention, and
Figure 7 shows diagrammatically a practical realisation of the integrated circuit of Figure 6.

As indicated above Figures 1 and 2 show symbols representing PNP transistors formed in an N-type process integrated circuit and Figures 3 and 4 show respective equivalent circuits thereof in which the respective isolation means 1, surrounding the transistors 2 is connected respectively to the emitter electrode and to the base electrode of the respective transistor 2.

Referring to Figure 5, in accordance with the present invention the isolation means 1 is connected to the base of the transistor 2 by way of a resistor 5 having a value of, say, 80Kohms. The isolation means 6 of the resistor 5 may be connected to the emitter electrode of the transistor 2.

Referring to Figure 6, the transistor 2 and the resistor 5 may be formed in adjacent N-type wells 7 and 8 in a P-type substrate 9, the transistor 2 being formed as successive P-type, N-type, P-type doping layers 10, 11 and 12 within the well 7 and the resistor 5 being formed as a P-type doping layer 13 in the well 8. As shown, the N-type well 7 is connected to one end of the doping layer 13 which forms the resistor 5, the other end of the layer 13 being connected to the N-type doping layer 11. The N-type well 8 is connected to the P-type doping layer 12. These connections may be made for example by means of surface metallisation layers.

The connections indicated in Figures 5 and 6 keep the input capacitance low, though slightly increased, while not increasing the saturation voltage. The provision of the resistor 5 occupies more chip area, and the time constant of the isolation capacitance and the resistor 5 must be arranged so not to be near the circuit switching time constant, but the resistor 5 increases the current drive capability of the transistor 2 by 100% and improves the stability of the circuit in which the transistor 2 is incorporated.

Referring now to Figure 7, a practical realisation of the integrated circuit of Figure 6 is shown based on a P-type substrate 14. The structure is formed in the following manner. Firstly, N+ regions 15,16 are formed by diffusion in substrate 14. A P-type epitaxial layer 17-21 is then formed, which buries the N+ regions 15, 16. Areas 18, 20 of the P-type epitaxial layer are then isolated from substrate 14 by diffusion of N+ type regions 22-25 to the buried N+ type layers 15, 16, which essentially form enclosures. PNP transistor 2 is formed in isolated P-type region 18 by shallow diffusion of N-type layer 26 and P-type layer 27.

The base region 26 of transistor 2 is connected to P-type region 20 from where a connection is made to isolation region 23. The isolation 24 of resistor 5 is preferably connected to the emitter region 27 of transistor 2. A shallow P+ region may be formed over the entire wafer to give the required sheet resistivity for fabricating resistors.

## Claims

1. A semiconductor integrated circuit in which isolation means of a first conductivity type is provided around a bipolar transistor formed in a semiconductor substrate of conductivity type opposite to said first type, wherein there are provided resistor means formed in said substrate for connecting the isolation means to the base electrode of the bipolar transistor.

2. A semiconductor integrated circuit in which a plurality of NPN bipolar transistors are formed in a P-type substrate, wherein a PNP bipolar transistor is formed in an N-type well formed in said substrate, and there are provided resistor means formed in or on said substrate for connecting the N-type well to the base electrode of said PNP transistor.

3. A semiconductor integrated circuit in accordance with Claim 2 wherein the resistor means is formed in a separate N-type well.

4. A semiconductor integrated circuit in accordance with Claim 3 wherein said separate N-type well is connected to the emitter electrode of the PNP transistor.
